# EUROPEAN PATENT APPLICATION

(11) **EP 4 580 071 A1**
(43) Date of publication of application: **02.07.2025**
(21) Application number: 23858813.1
(22) Date of filing: 16.06.2023
(51) Int. Cl.: H04B 1/00, H04B 1/04, H04B 1/401

(54) **MULTI-MODE MULTIBAND POWER AMPLIFIER DEVICE, SWITCHING METHOD, RADIO FREQUENCY FRONT-END APPARATUS, AND DEVICE**

(30) Priority: 01.09.2022 CN 202211066423
(71) Applicant: GUANGDONG OPPO MOBILE TELECOMMUNICATIONS CORP., LTD., Dongguan, Guangdong 523860 (CN)
(72) Inventor: CHEN, Feng, Dongguan, Guangdong 523860 (CN); TONG, Lin, Dongguan, Guangdong 523860 (CN)
(74) Representative: Novagraaf Technologies
(86) International application number: PCT/CN2023/100680
(87) International publication number: WO 2024/045774

(57) **Abstract**

A multi-mode multiband power amplifier (MMPA) device, a radio frequency front-end apparatus, and a wireless communication device. The MMPA comprises an intermediate frequency signal transmit pathway and a low frequency signal transmit pathway. The intermediate frequency signal transmit pathway comprises a first toggle switch, which is used to switch an input of the intermediate frequency signal transmit pathway when a radio frequency transceiver is connected to a plurality of other MMPAs to implement non-standalone networking so as to enable an intermediate frequency output channel of the radio frequency transceiver connected to the present MMPA to be different from intermediate frequency output channels connected to the other MMPAs. The low frequency signal transmit pathway comprises a second toggle switch, which is used to switch an input of the low frequency signal transmit pathway when the radio frequency transceiver is connected to the plurality of other MMPAs to implement non-standalone networking so as to enable a low frequency output channel of the radio frequency transceiver connected to the present MMPA to be different from low frequency output channels connected to the other MMPAs. According to the solutions of embodiments of the present disclosure, costs can be reduced and the area occupied by a PCB can be reduced.

## Description

The present disclosure claims priority of Chinese Patent Application No. 202211066423.4, entitled "MULTIMODE MULTIBAND POWER AMPLIFIER, SWITCHING METHOD, AND RADIO-FREQUENCY FRONT-END APPARATUS AND DEVICE", filed September 01, 2022, the entire content of which is incorporated in the present disclosure by reference.

### TECHNICAL FIELD

The embodiments of the present disclosure relate to the field of wireless radio-frequency technologies, and in particular to a multimode multiband power amplifier circuit, a radio-frequency system, and a wireless communication device.

### BACKGROUND

With the development and progress of technology, 5G mobile communication technology has gradually begun to be applied in an electronic device. With the increase in a communication network standard, a terminal device needs to support a communication requirement under various network standards such as 2G, 3G, 4G, and 5G. Due to a size constraint of the terminal device, space of a mainboard printed circuit board (PCB) has not increased significantly despite the increasing demand, resulting in extremely tight space layout and wiring of the mainboard PCB.

In order to support an ENDC, it is necessary to additionally use a multimode multiband power amplifier, which leads to undoubtedly exacerbate the already tight space layout and wiring problem, further increase the complexity of PCB layout and wiring, and raises the cost. ENDC is an abbreviation of EUTRA NR Dual-Connectivity. E represents Evolved-Universal Mobile Telecommunications System Terrestrial Radio Access (E-UTRA), which belongs to an air interface of 3GPP long-term evolution (LTE) and is an eighth version of the 3GPP. N represents New radio 5G, and D represents a dual connectivity between LTE and 5G. ENDC may be understood as a mutual compatibility of a dual connectivity between 4G and 5G.

### SUMMARY OF THE PRESENT DISCLOSURE

Some embodiments of the present disclosure provide a multimode multiband power amplifier (MMPA) circuit, a radio-frequency system, and a wireless communication device, such that it may be possible to improve an integration level of a radio-frequency device, save area, and reduce costs when implementing a dual connectivity.

According to an aspect, some embodiments of the present disclosure provide a multimode multiband power amplifier (MMPA), configured to be connected to a Radio Frequency (RF) Transceiver. The MMPA includes: an mid-band (MB) signal transmitting channel and a low-band (LB) signal transmitting channel, where the MB signal transmitting channel is configured to amplify an MB radio-frequency signal input by the RF Transceiver and output the amplified MB radio-frequency signal; and the LB signal transmitting channel is configured to amplify a LB radio-frequency signal input by the RF Transceiver and output the amplified LB radio-frequency signal; where the MB signal transmitting channel includes a first switch, the MB signal transmitting channel is configured to be connected to a first MB output channel and a second MB output channel of the RF Transceiver through the first switch respectively, the first switch is configured to switch an input of the MB signal transmitting channel to an output of the first MB output channel or an output of the second MB output channel in a case where the RF Transceiver is connected to a plurality of other MMPAs to implement a non-standalone network, and the MB output channel of the RF Transceiver connected to the MMPA is different from an MB output channel connected to any of the other MMPAs; and where the LB signal transmitting channel includes a second switch, the LB signal transmitting channel is configured to be connected to a first LB output channel and a second LB output channel of the RF Transceiver through the second switch respectively, the second switch is configured to switch an input of the LB signal transmitting channel to an output of the first LB output channel or an output of the second LB output channel in a case where the RF Transceiver is connected to the plurality of other MMPAs to implement the non-standalone network, and the LB output channel of the RF Transceiver connected to the MMPA is different from a LB output channel connected to any of the other MMPAs.

According to another aspect, some embodiments of the present disclosure provide a switching method for a MMPA, applicable to the MMPA described in the foregoing aspect, where the MMPA is connected to a RF Transceiver, the RF Transceiver is further connected to the other MMPAs, and the switching method includes: in a non-standalone network scenario, outputting, by the RF Transceiver, a first radio-frequency signal to the other MMPAs and a second radio-frequency signal to the MMPA through a plurality of output channels, respectively, where the first radio-frequency signal and the second radio-frequency signal are in different frequency bands; and determining, by the MMPA, whether to switch a connection between the MMPA and the RF Transceiver according to the output channel through which the RF Transceiver outputs the first radio-frequency signal to the other MMPAs, and the output channel through which the MMPA receives the second radio-frequency signal being different from the output channel through which any of the other MMPAs receives the first radio-frequency signal.

According to yet another aspect, some embodiments of the present disclosure provide a Radio-Frequency Front-End (RFFE) device. The RFFE device includes a RF Transceiver, a first MMPA and a second MMPA which are connected to the RF Transceiver; where the RF Transceiver is configured to respectively transmit a radio-frequency signal to the first MMPA and the second MMPA through an output channel, and a frequency band of the radio-frequency signal transmitted to the first MMPA is different from that of the radio-frequency signal transmitted to the second MMPA; the second MMPA is configured to switch an output channel of the RF Transceiver through which the second MMPA receives the radio-frequency signal according to an output channel through which the RF Transceiver sends the radio-frequency signal to the first MMPA, and the output channel through which the second MMPA receives the radio-frequency signal is different from an output channel through which the first MMPA receives the radio-frequency signal.

According to yet another aspect, some embodiments of the present disclosure provide a wireless communication device, including the RFFE device described in the foregoing aspect.

The MMPA provided by the embodiments of the present disclosure integrates a power amplifier supporting intermediate frequency and low frequency, and may be used in combination with an existing MMP A to support the non-standalone network, such that it may be possible to reduce the waste of a high-band (HB) amplification module, thereby saving costs and reducing an area occupied by a PCB.

Other features and advantages of the present disclosure will be further explained in the following description, and will partially become apparent from the description, or may be understood by implementing embodiments of the present disclosure. Other advantages of the present disclosure can be realized and obtained through the technical solutions described in the description, claims, and drawings.

### BRIEF DESCRIPTION OF THE DRAWINGS

The accompanying drawings are used for providing understanding of technical solutions of the present disclosure, constitute a part of the specification, and are used for explaining the technical solutions of the present disclosure together with embodiments of the present disclosure, but do not constitute a limitation to the technical solutions of the present disclosure. The shapes and sizes of the components in the accompanying drawings are not drawn to scale, the purpose of which is only to illustrate the present disclosure.
FIG. 1a is an architecture diagram of a radio-frequency system commonly applied to an electronic device.
FIG. 1b is a framework diagram of a current multimode multiband power amplifier (MMPA) module.
FIG. 2 is a structural schematic view of a multimode multiband power amplifier (MMPA) according to some embodiments of the present disclosure.
FIG. 3 is a structural schematic view of another MMPA according to some embodiments of the present disclosure.
FIG. 4 is a structural schematic view of yet another MMPA according to some embodiments of the present disclosure.
FIG. 5 is a structural schematic view of the MMPA in an application example.
FIG. 6 is a structural schematic view of a Radio-Frequency Front-End (RFFE) device in an application example.
FIG. 7 is a flowchart of a switching method for the MMPA according to some embodiments of the present disclosure.

### DETAILED DESCRIPTION

The present disclosure describes multiple embodiments, but the description is exemplary rather than restrictive, and it will be apparent to those skilled in the art that there may be more embodiments and implementations within the scope revealed by the embodiments described in the present disclosure. Although many possible combinations of features are shown in the drawings and discussed in the embodiments, many other combinations of the disclosed features are also possible. Except where specifically limited, any feature or element of an embodiment may be combined with or may replace any other feature or element of any other embodiment.

The present disclosure includes and contemplates combinations of features and elements known to those of ordinary skilled in the art. The disclosed embodiments, features and elements of the present disclosure may be combined with any conventional features or elements to form a unique inventive scheme defined by the claims. Any feature or element of any embodiment may also be combined with features or elements from other inventive solutions to form another unique inventive solution defined by the claims. Therefore, it should be understood that any of the features shown and discussed in the present disclosure may be implemented individually or in any suitable combination. Therefore, the embodiments are not otherwise limited except in accordance with the appended claims and equivalents thereof. In addition, various modifications and changes may be made within the protection scope of the appended claims.

Furthermore, when describing representative embodiments, the specification may have presented a method or process as a specific sequence of steps. However, to the extent that the method or the process does not depend on the specific order of steps described herein, the method or process should not be limited to the specific order of steps described. As those of ordinary skills in the art will understand, other orders of steps are also possible. Therefore, the specific order of steps set forth in the specification should not be interpreted as limitations on the claims. In addition, the claims for the method and/or the process should not be limited to the steps performed in the described order, and those of skilled in the art may easily understand that these orders may be varied but still remain within the essence and scope of the embodiments of the present disclosure.

In the embodiments of the present disclosure, anon-standalone (NSA) network mode may include any one of an EN-DC (E-UTRA and New radio Dual Connectivity) architecture, a NE-DC (New Radio and E-UTRA Dual Connectivity) architecture, and a NGEN-DC (Next Generation RAN E-UTRA New Radio-Dual Connectivity) architecture. Herein, DC represents Dual Connectivity, i.e., dual connectivity. E represents Evolved-Universal Mobile Telecommunications System Terrestrial Radio Access (E-UTRA), i.e., 4G radio access network. N represents New Radio (NR), i.e., 5G NR. NG represents a next-generation core network, i.e., a 5G core network.

In an EN-DC architecture, a core network is a 4G core network, a 4G base station is a master station, and a 5G base station is a slave station. EN-DC refers to the dual connectivity between the 4G radio access network and the 5G NR. In an NE-DC architecture, the core network is the 5G core network, the 5G base station is the master station, and the 4G base station is the slave station. NE-DC refers to the dual connectivity between 5G NR and the 4G radio access network. In the NGEN-DC architecture, the core network is the 5G core network, the 4G base station is the master station, and the 5G base station is the slave station. NGEN-DC refers to the dual connectivity between the 4G radio access network and 5the G NR under the 5G core network.

For the convenience of description, in some embodiments of the present disclosure, as an example, the NSA network mode may be based on the EN-DC architecture. Other NSA network modes can be implemented by reference.

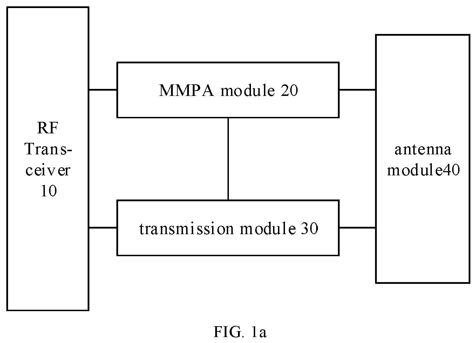

As shown in FIG. 1a, which illustrates an architecture of a radio-frequency system commonly applied to an electronic device such as a mobile phone, etc. The radio-frequency system includes a Radio Frequency (RF) Transceiver 10, a multimode multiband power amplifier (MMPA) module 20, a transmission module 30 (the transmission module is also called a TXM module), and an antenna module 40. The RF Transceiver 10 is connected to the MMPA module 20 and the transmission module 30. The MMPA module 20 and the transmission module 30 are connected to the antenna module 40. The RF Transceiver 10 is configured to transmit or receive a radio-frequency signal through a signal channel of the MMPA module 20 and a signal channel of the antenna module 40. Alternatively, a user may transmit or receive the radio-frequency signal through the transmission module 30 and the antenna module 40. In addition, the MMPA module 20 may also be connected to the transmission module 30, such that a signal processing channel may be formed to implement transmitting or receiving the radio-frequency signal through a corresponding antenna.

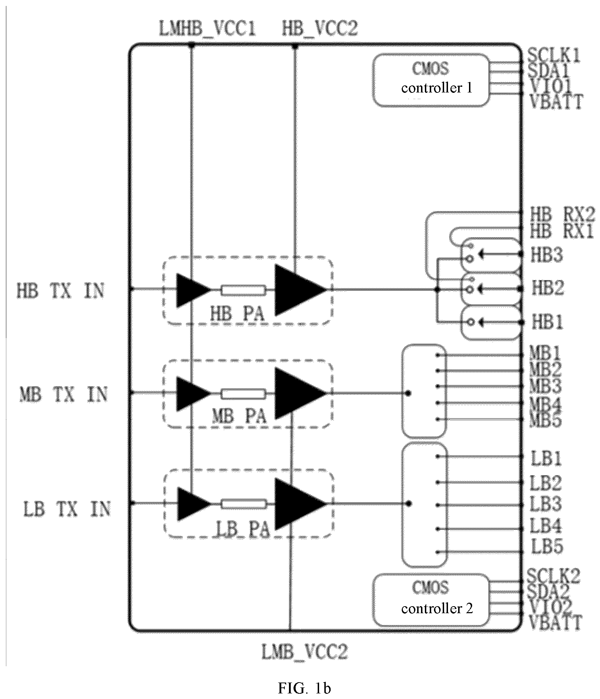

A framework diagram of the MMPA module is shown in FIG. 1b. The MMPA module is configured with a port HB TX IN configured to receive a high-band (HB) transmit signal, a port MB TX IN configured to receive an MB transmit signal, a port LB TX IN configured to receive a LB transmit signal, multiple HB output ports (such as a port HB1, a port HB2, and a port HB3 as shown in the figure), multiple HB receiving ports (such as a port HB RX1 and a port HB RX2 as shown in the figure), multiple MB transmission ports (such as a port MB1, a port MB2, a port MB3, a port MB4, and a port MB5 as shown in the figure), multiple LB transmission ports (such as a port LB1, a port LB2, a port LB3, a port LB4, and a port LB5 as shown in the figure), multiple power supply ports (such as a port LMHB_VCC1, a port HB_VCC2, and a port LMB_VCC2 as shown in the figure), and multiple controllers. Each controller is connected to multiple controller ports (such as a port SCLK1, a port SDA1, a port VIO1, a port SCLK2, a port SDA2, a port VIO2, and a port VBATT as shown in the figure). The MMP A module includes a HB amplification circuit HB PA, an MB amplification circuit MB Power Amplifier (PA), and a LB amplification circuit LB PA. The HB amplification circuit includes a HB frontend PA (the PA close to the port HB TX IN as shown in the figure), a HB matching circuit, and a HB post-stage PA (the PA far from the port HB TX IN as shown in the figure), which are cascaded with each other. The MB amplification circuit includes a MB frontend PA (the PA close to the port MB TX IN as shown in the figure), an MB matching circuit, and an MB post-stage PA (the PA far from the port MB TX IN as shown in the figure), which are cascaded with each other. The LB amplification circuit includes a LB frontend PA (the PA close to the port LB TX IN as shown in the figure), a LB matching circuit, and a LB post-stage PA (the PA far from the port LB TX IN as shown in the figure), which are cascaded with each other. A power supply terminal of the HB frontend PA, a power supply terminal of the MB frontend PA, and a power supply terminal of the LB frontend PA are connected to the power supply port LMHB_VCC1. A power supply terminal of the HB post-stage PA is connected to the power supply port HB_VCC2. A power supply terminal of the MB post-stage PA and a power supply terminal of the LB post-stage PA are connected to the power supply port LMB_VCC2.

It can be seen that the current MMPA module integrates the PAs supporting low frequency, intermediate frequency, and high frequency, and an operating frequency range of the current MMPA module may be from 663 MHz to 2690 MHz, when used in combination to support the ENDC, two MMP A modules are required. However, since there is no HB+HB ENDC requirement, it may cause a waste of the HB PA in one MMPA, and the cost cannot be optimized. At the same time, an existing MMPA component does not support switching between power supply and the radio-frequency input signal, making it impossible to flexibly select a VCC power supply and a PA input channel according to a specific solution when implementing different ENDC combinations.

In some embodiments, in order to support 5G Ultra High Band (UHB) N77 (or N78), it is necessary to additionally incorporate a single PA configured for supporting the N77. The cost price of the single PA configured for supporting N77 is approximately $1.5, and the single PA supporting N77 may occupy about 15mm² of a PCB area. At the same time, a single PA module cannot implement ENDC combinations of L+M (i.e., LB and MB) and L+H (i.e., LB and HB).

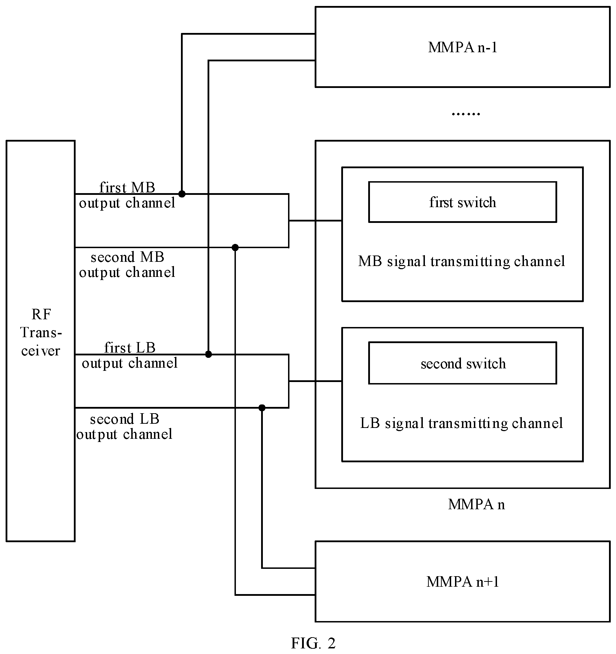

Based on above, some embodiments of the present disclosure provide a MMPA. As shown in FIG. 2, the MMPA n shown in the figure is the MMPA described in the embodiments. A MMPA n-1 and a MMPA n+1 shown in the figure are multiple other MMPAs connected to a RF Transceiver. The number of other MMP As connected to the RF Transceiver may be one or two. The MMPA provided in the embodiments is configured to be connected to the RF Transceiver. The MMPA includes an MB signal transmitting channel and a LB signal transmitting channel. The MB signal transmitting channel is configured to amplify an MB radio-frequency signal input by the RF Transceiver and output the amplified MB radio-frequency signal. The LB signal transmitting channel is configured to amplify a LB radio-frequency signal input by the RF Transceiver and output the amplified LB radio-frequency signal.

The MB signal transmitting channel includes a first switch. The MB signal transmitting channel is configured to be connected to a first MB output channel and a second MB output channel of the RF Transceiver through the first switch respectively. The first switch is configured to switch an input of the MB signal transmitting channel to the output of the first MB output channel or an output of the second MB output channel in a case where the RF Transceiver is connected to the multiple other MMPAs to implement the NSA network, so that the MB output channel of the RF Transceiver connected to the MMPA is different from an MB output channel connected to any of the other MMPAs.

The LB signal transmitting channel includes a second switch. The LB signal transmitting channel is configured to be connected to a first LB output channel and a second LB output channel of the RF Transceiver through the second switch respectively. The second switch is configured to switch an input of the LB signal transmitting channel to an output of the first LB output channel or an output of the second LB output channel in a case where the RF Transceiver is connected to the multiple other MMPAs to implement the NSA network, so that the LB output channel of the RF Transceiver connected to the MMPA is different from a LB output channel connected to any of the other MMPAs.

By using the MMP A module provided by the embodiments of the present disclosure, the PA supporting the intermediate frequency and the low frequency may be integrated, and the MMP A module may be used in combination with other transmission modules (such as an existing MMPA module) to support the NSA network. In this way, it may be possible to reduce the waste of a HB power amplifier, thereby saving costs (for example, at least $0.2 may be saved by replacing the existing MMPA module with each MMP A module provided in the embodiments of the present disclosure) and reducing an area occupied by a PCB (for example, more than 10 mm² may be saved). An operating frequency range of the MMPA module provided in the embodiments of the present disclosure may be from 600MHz to 2000MHz.

In an exemplary embodiment, the first switch may be a Single Pole Multiple Throw (SPxT) switch, i.e., a type of multi-way selective switch. An P port of the SPxT switch is connected to an input end of the MB amplification circuit, and multiple T ports, i.e., x T ports, are connected to multiple MB input ports, respectively. x is a positive integer greater than or equal to 2, for example, x=2. A value of x may be determined according to the number of the MB input ports. In the embodiments, a full English name of the P port is a Pole port, which may be used as the name for an input port or an output port in the multi-way selective switch. A full English name of the T port is Throw, which may be used as the name for an output port or an input port in the multi-way selective switch. For example, in an SP4T switch, S represents Single. By setting the first switch, it may be possible to enable the MMPA component to support the switching of the MB input signal, thereby flexibly selecting a PA input channel according to a specific solution when implementing different ENDC combinations.

In an exemplary embodiment, the second switch may be a Single Pole Multiple Throw (SPyT) switch. An P port of the SPyT switch is connected to an input end of the LB amplification circuit, and multiple T ports, i.e., y T ports, are connected to multiple LB input ports, respectively. y is a positive integer greater than or equal to 2. y may be the same as or different from x. For example, y=2. A value of y may be determined according to the number of the LB input ports. By setting the second switch, it may be possible to enable the MMPA component to support the switching of the LB input signal, thereby flexibly selecting the PA input channel according to a specific solution when implementing the different ENDC combinations.

In an exemplary embodiment, the MMP A may further include multiple power supply ports configured to be connected to a power supply and a third switch connected to the multiple power supply ports. The third switch is configured to switch the multiple power supply ports connected to the power supply in a case where the RF Transceiver is connected to the multiple other MMPAs to implement the NSA network, so that the power supply connected to the MMPA is different from a power supply connected to any of the other MMPAs.

An input end of the third switch is connected to the multiple power supply ports, and each of the multiple power supply port is connected to a power supply. An output end of the third switch is connected to the MB amplification circuit and the LB amplification circuit, respectively. The third switch is configured to select a power supply for supplying power to the MB amplification circuit and the LB amplification circuit.

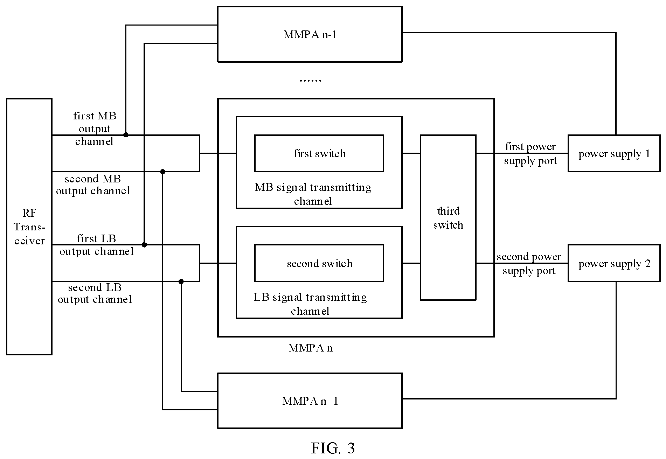

As shown in FIG. 3 as an example, the MMPA n shown in the figure is the MMPA described in the embodiments. The power supply includes a power supply 1 and a power supply 2. The power supply 1 is connected to a first power supply port, and the power supply 2 is connected to a second power supply port. When implementing the NSA network, in a case where the MMPA n works together with the MMPA n-1, the MMPA n-1 is connected to the power supply 1, and the third switch is switched to be connected to the second power supply port, that is, it may be possible to realize that the MMPA n is powered by the power supply 2, so as to realize that the two MMPAs are powered by different power supplies.

In some embodiments, the third switch may be a Single Pole Multiple Throw (SPzT) switch. An P port of the SPzT switch is connected to a power supply terminal of the MB amplification circuit and a power supply terminal of the LB amplification circuit. Multiple T ports, i.e., z T ports, are connected to multiple power supply ports, respectively. z is a positive integer greater than or equal to 2, for example, z=2. A value of z may be determined according to the number of the power supply ports. By setting the third switch, it may be possible to enable the MMP A component to support power supply switching, thereby flexibly selecting the power supply of the amplification circuit according to a specific solution when implementing the different ENDC combinations.

In an exemplary embodiment, each signal transmitting channel in the MMPA include an amplification circuit. The third switch includes multiple input ports, the multiple input ports are connected to the power supply ports in one-to-one correspondence. An output port of the third switch is connected to the amplification circuit in the each signal transmitting channel.

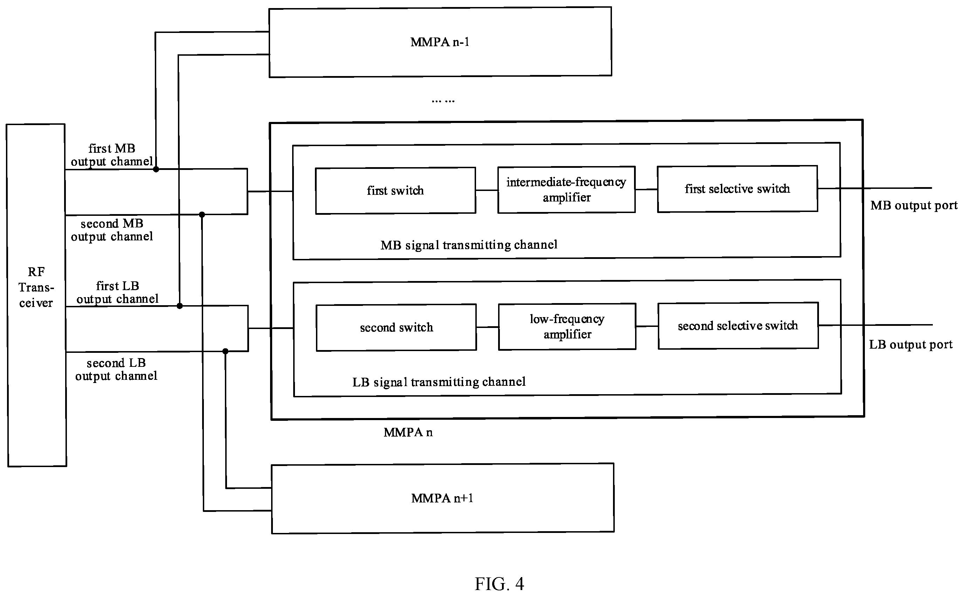

In an exemplary embodiment, as shown in FIG. 4, the MB signal transmitting channel further includes: an MB amplification circuit, a first selective switch, and multiple MB output ports. An output port of the first switch is connected to an input port of the MB amplification circuit. An output port of the MB amplification circuit is connected to an input port of the first selective switch. An output port of the first selective switch is connected to the multiple MB output ports respectively. The first selective switch is configured to select a corresponding one of the MB output ports for outputting the MB radio-frequency signal.

The first selective switch may be a Single Pole Multiple Throw (SPmT) switch, i.e., a type of multi-way selective switch. An P port of the SPmT switch is connected to an output end of the MB amplification circuit, and multiple T ports, i.e., m T ports, are connected to multiple MB output ports, respectively. m is a positive integer greater than or equal to 2, for example, m=4. A value of m may be determined according to the number of the MB output ports.

In an exemplary embodiment, as shown in FIG. 4, the LB signal transmitting channel further includes: a LB amplification circuit, a second selective switch, and multiple LB output ports. An output port of the second switch is connected to an input port of the LB amplification circuit. An output port of the LB amplification circuit is connected to an input port of the second selective switch. An output port of the second selective switch is connected to the multiple LB output ports respectively. The second selective switch is configured to select a corresponding one of the LB output ports configured to for outputting the LB radio-frequency signal.

The second selective switch may be a Single Pole Multiple Throw (SPnT) switch. An P port of the SPnT switch is connected to an output end of the LB amplification circuit, and multiple T ports, i.e., n T ports, are connected to multiple LB output ports, respectively. n is a positive integer greater than or equal to 2, for example, n=5. A value of n may be determined according to the number of the LB output ports.

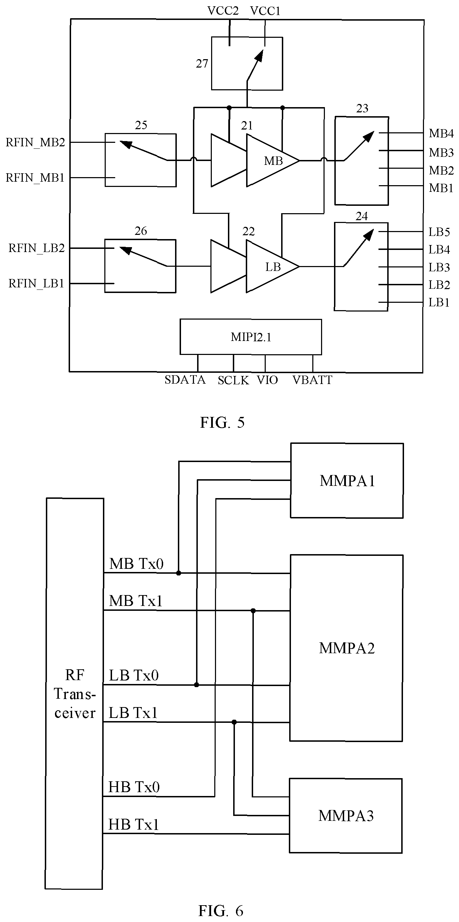

The following takes an example to specifically illustrate the embodiments of the present disclosure. As shown in FIG. 5, the MMPA provided in the embodiments includes two MB input ports RFIN_MB1 and RFIN_MB2, four MB output ports MB1, MB2, MB3, and MB4, two LB input ports RFIN_LB1 and RFIN_LB2, five LB output ports LB1, LB2, LB3, LB4, and LB5, and two power supply ports VCC1 and VCC2.

The MMPA provided in the embodiments includes an MB transmitting channel and a LB transmitting channel. The MB transmitting channel includes a switch 25, an MB amplification circuit MB, and a selective switch 23 which are connected in sequence. The switch 25 is a Single Pole double Throw (SPDT), and two T ports of the SPDT are connected to the two MB input ports. The selective switch 23 is a SP4T, and multiple T ports of the SP4T are connected to the four MB output ports, respectively. The LB transmitting channel includes a switch 26, a LB amplification circuit LB, and a selective switch 24 which are connected in sequence. The switch 26 is a SPDT, and two T ports of the SPDT are connected to the two LB input ports. The selective switch 24 is an SP5T, and multiple T ports of the SP5T are connected to the five LB output ports, respectively.

The MMPA has two power supply ports VCC1 and VCC2. In order to implement flexible selection of the power supply module, a switch 27 is arranged. In the embodiments, the switch 27 is a SPDT, and two T ports of the SPDT are connected to the two power supply ports, respectively, and an S port of the SPDT is connected to a power supply terminal of each PA circuit.

The MMPA provided in the embodiments includes a controller (such as MIPI 2.1 shown in the figure, where MIPI represents a Mobile Industry Processor Interface, and 2.1 represents a supported protocol version). The controller is connected to a port SDATA, a port SCLK, a port VIO, and a port VBATT, respectively. The controller is configured to receive a MIPI BUS control signal through the port SCLK and the port SDATA, receive a MIPI power supply signal of the port VIO, and receive a bias voltage signal of the port VBATT.

The MMPA component provided in the embodiments integrates a LB PA and a MB PA, and may support the amplification of any one of radio-frequency signals in 3G, 4G, and 5G. When the LB is working, the LB radio-frequency signal may enter the MMPA through the port RFIN_LB1 or the port RFIN_LB2. The port RFIN_LB1 and the port RFIN_LB2 may be connected to two independent LB transmitting channels (Tx chain) of a RF Transceiver respectively, such as a LB Tx chain0 and a LB Tx chain1. Since the RF Transceiver requires that radio-frequency signals in two frequency bands in the ENDC combination for transmitting should belong to different Tx chains respectively, a selective switch is arranged on an input port side, such that it may be possible to implement flexible selection of the input channel. In this way, it may be convenient for flexibly selecting the Tx chain when cooperating with other PAs to implement the ENDC. After passing through the SPDT switch 26, the LB radio-frequency signal is connected to the LB PA for radio-frequency signal power amplification. The amplified radio-frequency signal is output through one of the ports LB1-LB5 selected by the SP5T radio-frequency switch, and may be connected to an external LB filter.

The MB may operate in a similar manner to the LB. The MB radio-frequency signal enters the MMPA through the port RFIN_MB1 or the port RFIN_MB2. The port RFIN_MB1 and the port RFIN_MB2 may be connected to two independent MB transmitting channels of the RF Transceiver respectively. After passing through the SPDT switch 25, the MB radio-frequency signal is connected to the MB PA for radio-frequency signal power amplification. The amplified radio-frequency signal is output through one of the ports MB1-MB4 selected by the SP4T radio-frequency switch, and may be connected to an external MB filter.

An external power supply enters the MMPA through the port VCC1 or the port VCC2, and supplies power to the LB PA and the MB PA through the power supply switch (VCC SWITCH) 27. The port VCC1 and the port VCC2 may be connected to two independent radio-frequency power supplies respectively, i.e., Power Management ICs (PMICs), such as PMIC#0 and PMIC#1. Since the RF Transceiver requires that power supplies of the radio-frequency signal power amplifiers PA of the two frequency bands used for transmission in the ENDC combination should belong to different radio-frequency power supply PMICs respectively, the selective switch 27 is arranged on a power supply port side, such that it may be possible to implement flexible selection of the power supply. In this way, it may be convenient for flexibly selecting the radio-frequency power supply PMIC when cooperating with other PAs to implement the ENDC.

In the MMPA provided in the embodiments, the number of MB output ports and the number of LB output ports are only for illustration, which may be different in other embodiments and may be determined according to the number of subsequent connected filters.

Based on the requirement that the PA power supplies and transmitting channels of the two transmit signals should be independent of each other during the ENDC implementation process, the MMPA module provided in the embodiments not only integrates the LB PA and the MB PA, but also supports the power supply VCC switching and the PA input signal switching function. When cooperating with the other PAs to implement the ENDC, it may be possible to flexibly switch the PA power supply and the radio-frequency input signal as needed, and it may also be possible to implement more ENDC combinations with fewer external devices, such that it may be beneficial to reducing the cost of the entire solution.

The MMPA provided in the embodiments may support any dual connectivity scenario, such as EN-DC, NE-DC, NGEN-DC, or Carrier Aggregation (CA). The embodiment is described by taking the dual connectivity between the 4G and the 5G as an example, however, those skilled in the art should be understood that the embodiments may be applied to any possible dual-connectivity scenario or multi-connectivity scenario. In addition, frequency bands of dual-transmission signals are not limited herein, and may be any combination of frequency bands. In some embodiments, the frequency bands of the dual-transmission signals may be in a form of P+Q. A P frequency band may include any one of B1, B3, B39, B41, B77, B78, N1, N3, N39, N41, N77, and N78. A Q frequency band may include any one of the following frequency bands different from the P frequency band: B1, B3, B39, B41, B77, B78, N1, N3, N39, N41, N77, and N78.

FIG. 6 is a structural schematic view of a radio-frequency front-end (RFFE) device according to some embodiments of the present disclosure. The RFFE device includes a RF Transceiver and three MMPAs (i.e., a MMPA 1, a MMPA 2, and a MMPA 3). The RF Transceiver may be capable of outputting the HB signal, the MB signal, and the LB signal. Each type of the HB signal, the MB signal, and the LB signal has two output channels Tx0 and Tx1. As shown in FIG. 6, the MMPA 1 and the MMPA 3 are existing PAs, and the MMPA 2 is the PA provided in the embodiments of the present disclosure. For example, when the MMPA 1 and the MMPA 2 are required to implement a dual connectivity between the LB and the HB, the MMPA 1 is connected to the HB Tx0 channel of the RF Transceiver, and the MMPA 2 needs to be switched through an internal switch, so that the LB signal transmitting channel is connected to the LB Tx1 channel of the RF Transceiver, thereby meeting the requirement that radio-frequency signals of two transmitted frequency bands belong to different channels respectively. When the MMPA 2 and the MMPA 3 are required to implement a dual connectivity between the LB and a ultra-HB, the MMPA 2 needs to be switched through an internal switch at the time due to a case where the MMPA 3 is connected to the HB Tx1 channel of the RF Transceiver, so that the LB signal transmitting channel is connected to the LB Tx0 channel of the RF Transceiver.

For the switching of the power-supply port, still taking the above embodiment as an illustration, when the MMPA 1 and the MMPA 2 are required to implement the dual connectivity, the third switch in the MMPA 2 is switched to be connected to the second power supply in a case where the MMPA 1 is connected to the first power supply. When the MMPA 2 and the MMPA 3 are required to implement the dual connectivity, the third switch in the MMPA 2 is switched to be connected to the first power supply in a case where the MMPA 3 is connected to the second power supply, such that it may be possible to meet the requirement that the power supplies of two radio-frequency signal PAs during the dual connectivity belong to different radio-frequency power supplies respectively.

It may be seen that by using the MMPA 2 of the embodiments of the present disclosure, it may be possible to save the HB amplifier in the MMPA, and the configuration may be more flexible. Compared with the existing solution to meet the requirement of the RF Transceiver, fewer connection lines may be required to meet the needs.

In other embodiments, the number of the MMP As connected to the RF Transceiver is not limited to this.

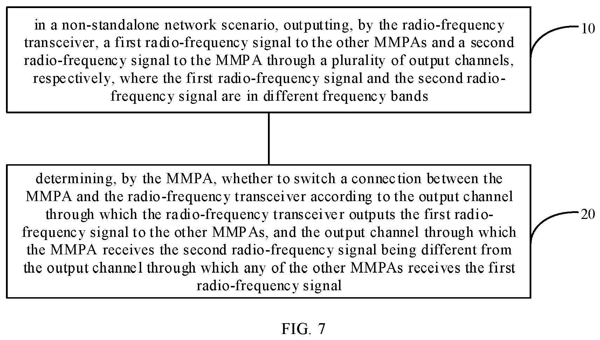

The embodiments of the present disclosure further provide a switching method for the MMPA. The switching method for the MMPA may be applicable to the MMPA described in any of the foregoing embodiments. The MMPA is connected to a RF Transceiver, and the RF Transceiver is further connected to the other MMPAs. The switching method is shown in FIG. 7 and includes the following operations.

At block 10, in an NSA network scenario, the RF Transceiver outputs a first radio-frequency signal to the other MMPAs and a second radio-frequency signal to the MMPA through multiple output channels, respectively. The first radio-frequency signal and the second radio-frequency signal are in different frequency bands.

At block 20, the MMPA determines whether to switch a connection between the MMPA and the RF Transceiver according to the output channel through which the RF Transceiver outputs the first radio-frequency signal to the other MMPAs, and the output channel through which the device receives the second radio-frequency signal is different from the output channel through which any of the other MMPAs receives the first radio-frequency signal.

In an exemplary embodiment, the method further includes: determining, by the MMPA, whether to switch the power supply connected to the MMP A according to the output channel through which the RF Transceiver outputs the first radio-frequency signal to the other MMP As, and the power supply connected to the MMP A being different from the power supply connected to any of the other MMPAs.

The embodiments of the present disclosure further provide a RFFE device. The RFFE device includes a RF Transceiver, a first MMPA and a second MMPA which are connected to the RF Transceiver.

The RF Transceiver is configured to respectively transmit a radio-frequency signal to the first MMPA and the second MMPA through an output channel. A frequency band of the radio-frequency signal transmitted to the first MMPA is different from that of the radio-frequency signal transmitted to the second MMPA.

The second MMPA is configured to switch an output channel of the RF Transceiver through which the second MMPA receives the radio-frequency signal according to an output channel through which the RF Transceiver sends the radio-frequency signal to the first MMPA. The output channel through which the second MMPA receives the radio-frequency signal is different from an output channel through which the first MMPA receives the radio-frequency signal.

In an exemplary embodiment, the second MMPA is further configured to switch the power supply connected to the second MMPA according to the power supply connected to the first MMPA, so that the power supply connected to the second MMPA is different from a power supply connected to the first MMPA.

The second MMPA is the MMPA module provided in the embodiments of the present disclosure. The MMPA module may be capable of supporting the LB signal and/or the HB signal. The LB signal is a LB signal of any one of a 3G network, a 4G network, and a 5G network. The MB signal is an MB signal of any one of the 3G network, the 4G network, and the 5G network.

The embodiments of the present disclosure further provide a wireless communication device. The wireless communication device includes the above-mentioned radio-frequency system. The wireless communication device provided in the embodiments of the present disclosure may include various handheld devices with RF Transceiver functions, vehicle-mounted devices, virtual reality/augmented reality devices, wireless earphones, smart home devices, wearable devices, computing devices, or other processing devices connected to a wireless modem, as well as various forms of user equipment (UE, such as mobile phones), mobile stations (MS), terminal devices, and so on.

It should be note that, in the present disclosure, unless otherwise definitely specified and limited, the terms "installed", "joined", "connected" should be understood in a broad sense, for example, they can be fixed connections or detachable connections, or integrally connected. In some embodiments, they can be mechanical connections or electrical connections. In some embodiments, they can be direct connections or indirect connections through intermediate mediums, and they can be an internal communication between two components. For those of ordinary skills in the art, the specific meanings of the above-mentioned terms in the present disclosure can be understood according to specific circumstances.

The above-mentioned embodiments only express a few implementations of the present disclosure, the description thereof is relatively specific and detailed, but they could not be construed as a limitation on the scope of the patent application. It should be pointed out that, for those of ordinary skills in the art, without departing from the concept of this application, several modifications and improvements could be made, and these all fall within the protection scope of the present disclosure. Therefore, the protection scope of this patent application should be subject to the appended claims.

## Claims

1. A multimode multiband power amplifier, MMPA, configured to be connected to a Radio Frequency, RF, Transceiver, and the MMPA comprising: an mid-band, MB, signal transmitting channel and a low-band, LB, signal transmitting channel, wherein the MB signal transmitting channel is configured to amplify an MB radio-frequency signal input by the RF Transceiver and output the amplified MB radio-frequency signal; and the LB signal transmitting channel is configured to amplify a LB radio-frequency signal input by the RF Transceiver and output the amplified LB radio-frequency signal;
wherein the MB signal transmitting channel comprises a first switch, the MB signal transmitting channel is configured to be connected to a first MB output channel and a second MB output channel of the RF Transceiver through the first switch respectively, the first switch is configured to switch an input of the MB signal transmitting channel to an output of the first MB output channel or an output of the second MB output channel in a case where the RF Transceiver is connected to a plurality of other MMPAs to implement a non-standalone network, and the MB output channel of the RF Transceiver connected to the MMPA is different from an MB output channel connected to any of the other MMPAs; and
wherein the LB signal transmitting channel comprises a second switch, the LB signal transmitting channel is configured to be connected to a first LB output channel and a second LB output channel of the RF Transceiver through the second switch respectively, the second switch is configured to switch an input of the LB signal transmitting channel to an output of the first LB output channel or an output of the second LB output channel in a case where the RF Transceiver is connected to the plurality of other MMPAs to implement the non-standalone network, and the LB output channel of the RF Transceiver connected to the MMPA is different from a LB output channel connected to any of the other MMPAs.

2. The MMPA according to claim 1, wherein the MMPA further comprises a plurality of power supply ports configured to be connected to a power supply and a third switch connected to the plurality of power supply ports, the third switch is configured to switch the plurality of power supply ports connected to the power supply in a case where the RF Transceiver is connected to the plurality of other MMPAs to implement the non-standalone network, and the power supply connected to the MMPA is different from a power supply connected to any of the other MMPAs.

3. The MMPA according to claim 2, wherein each signal transmitting channel in the MMPA comprises an amplification circuit; and
the third switch comprises a plurality of input ports, the plurality of input ports are connected to the plurality of power supply ports in one-to-one correspondence, and an output port of the third switch is connected to the amplification circuit in the each signal transmitting channel.

4. The MMPA according to claim 1, wherein the MB signal transmitting channel further comprises: an MB amplification circuit, a first selective switch, and a plurality of MB output ports;
wherein an output port of the first switch is connected to an input port of the MB amplification circuit, an output port of the MB amplification circuit is connected to an input port of the first selective switch, an output port of the first selective switch is connected to the plurality of MB output ports respectively, and the first selective switch is configured to select a corresponding one of the MB output ports for outputting the MB radio-frequency signal.

5. The MMPA according to claim 1, wherein the LB signal transmitting channel further comprises: a LB amplification circuit, a second selective switch, and a plurality of LB output ports;
wherein an output port of the second switch is connected to an input port of the LB amplification circuit, an output port of the LB amplification circuit is connected to an input port of the second selective switch, an output port of the second selective switch is connected to the plurality of LB output ports respectively, and the second selective switch is configured to select a corresponding one of the LB output ports for outputting the LB radio-frequency signal.

6. A switching method for a MMPA, applicable to the MMPA according to any one of claims 1-5, wherein the MMPA is connected to the RF Transceiver, the RF Transceiver is further connected to the other MMPAs, and the switching method comprises:
in a non-standalone network scenario, outputting, by the RF Transceiver, a first radio-frequency signal to the other MMPAs and a second radio-frequency signal to the MMPA through a plurality of output channels, respectively, wherein the first radio-frequency signal and the second radio-frequency signal are in different frequency bands; and
determining, by the MMPA, whether to switch a connection between the MMPA and the RF Transceiver according to the output channel through which the RF Transceiver outputs the first radio-frequency signal to the other MMPAs, and the output channel through which the MMPA receives the second radio-frequency signal being different from the output channel through which any of the other MMPAs receives the first radio-frequency signal.

7. The switching method for a MMPA according to claim 6, wherein the method further comprises:
determining, by the MMPA, whether to switch the power supply connected to the MMPA according to the output channel through which the RF Transceiver outputs the first radio-frequency signal to the plurality of other MMPAs, and the power supply connected to the MMPA being different from the power supply connected to any of the other MMPAs.

8. A Radio Frequency Front-End, RFFE, device, comprising a RF Transceiver, a first MMPA and a second MMPA which are connected to the RF Transceiver;
wherein the RF Transceiver is configured to respectively transmit a radio-frequency signal to the first MMPA and the second MMPA through an output channel, and a frequency band of the radio-frequency signal transmitted to the first MMPA is different from that of the radio-frequency signal transmitted to the second MMPA;
the second MMPA is configured to switch an output channel of the RF Transceiver through which the second MMPA receives the radio-frequency signal according to an output channel through which the RF Transceiver sends the radio-frequency signal to the first MMPA, and the output channel through which the second MMPA receives the radio-frequency signal is different from an output channel through which the first MMPA receives the radio-frequency signal.

9. The RFFE device according to claim 8, wherein the second MMPA is further configured to switch the power supply connected to the second MMPA according to the power supply connected to the first MMPA, and the power supply connected to the second MMPA is different from a power supply connected to the first MMPA.

10. A wireless communication device, comprising the RFFE device according to claim 8 or 9.
